# EUROPEAN PATENT APPLICATION

(11) **EP 3 550 396 A1**
(43) Date of publication of application: **09.10.2019**
(21) Application number: 19165023.3
(22) Date of filing: 25.03.2019
(51) Int. Cl.: G05F 1/575, G05F 1/618, H01L 23/498

(54) **METHODS AND SYSTEMS FOR SUPPLY NOISE SUPPRESSION IN SYSTEMS-ON-CHIP**

(30) Priority: 03.04.2018 US 201862651785 P; 12.12.2018 US 201816218260
(71) Applicant: MediaTek Singapore Pte. Ltd., Singapore 138628 (SG)
(72) Inventor: Park, Henry Arnold, Irvine, CA 95134 (US); Ali, Tamer Mohammed, Irvine, CA 95134 (US); Chen, E-Hung, Irvine, CA 95134 (US); Chen, Huan-Sheng, 30078 Hsinchu City (TW)
(74) Representative: Gilani, Anwar

(57) **Abstract**

Systems and method for supply noise suppression in electronic circuits are described. The systems described herein may prevent or at least limit noise coupling from a supply line to a load, and may further prevent or at least limit noise generated at the load from coupling to the supply line. The systems and methods described herein may be particularly useful in systems-on-chip with multi-level interposers, in which multiple supply lines are used to provide different voltage levels to the chip. In these systems, in fact, the supply lines can exhibit large impedances, which may in turn promote noise coupling from one circuit to another. In one example, a voltage regulator is provided that includes a linear regulator and an active shunt circuit.

## Description

### FIELD OF INVENTION

The present application relates to methods and systems for suppressing supply noise in systems-on-chip (SoC).

### BACKGROUND

Systems-on-chip (SoC) are integrated circuits that combine multiple electronic components on a common chip. These components typically include a central processing unit (CPU), memory, input/output ports, secondary storage, mixed-signal components, and/or radio frequency signal processing functions, among others.

SoC are often used in connection with interposers. Interposers are electrical interfaces enabling signal routing between connections. The purpose of an interposer is to spread connections to a wider pitch or to reroute a connection to a different connection.

### BRIEF SUMMARY

Some embodiments are directed to a system-on-chip (SoC) comprising a chip comprising a first electronic circuit and a second electronic circuit, and a multi-layer interposer. The multi-layer interposer comprises a ground line including at least one via and connecting the first and second electronic circuits to a ground terminal and a supply line including at least one via and connecting the first and second electronic circuits to a power supply. The first electronic circuit comprises a load, a linear voltage regulator coupled between the supply line and the load, and an active shunt circuit coupled to the linear voltage regulator and to the ground line.

The linear voltage regulator may have a first impedance and a second impedance, the first impedance representing an impedance of the linear voltage regulator seen by the supply line and the second impedance representing an impedance of the linear voltage regulator seen by the load, the first impedance being lower than the second impedance.

The first impedance may represent a source impedance or an emitter impedance, and the second impedance represents a drain impedance or a collector impedance.

The linear voltage regulator may comprise a low-drop out (LDO) regulator.

The first electronic circuit may be a digital circuit and the second electronic circuit may be an analog circuit.

The active shunt circuit may comprise an operational amplifier and a transistor, the operational amplifier having an output coupled to a gate or a base of the transistor.

The SoC may lack capacitors coupled between the supply line and the source line and having capacitances greater than 1nF.

Some embodiments are directed to a circuit electrically coupled to a supply line and a ground line. The circuit comprises a load and a voltage regulator. The voltage regulator comprises a linear voltage regulator coupled to the load and the supply line, the linear voltage regulator having a first impedance and a second impedance, the first impedance representing an impedance of the linear voltage regulator seen by the supply line and the second impedance representing an impedance of the linear voltage regulator seen by the load, the first impedance being lower than the second impedance; and an active shunt circuit coupled to the linear voltage regulator and to the ground line.

The first impedance may represent a source impedance or an emitter impedance, and the second impedance may represent a drain impedance or a collector impedance.

The load may be a digital circuit.

The active shunt circuit may comprise an operational amplifier and a transistor, the operational amplifier having an output coupled to a gate or a base of the transistor.

The first electronic circuit may further comprise a low-pass filter coupled to the gate or base of the transistor.

The linear voltage regulator may comprise a PMOS transistor coupled between the load and the supply line.

The circuit may further comprise a feedback circuit coupling the active shunt circuit to the linear voltage regulator, the feedback circuit comprising a current mirror.

The linear voltage regulator may comprise a low-drop out regulator.

Some embodiments are directed to a method for supplying power to a load. The method may comprise providing a supply voltage to a linear voltage regulator through a supply line comprising at least one via, the linear voltage regulator being coupled to the load; reducing coupling of noise present at the supply line to the load using the linear voltage regulator; and reducing coupling of noise generated at the load to the supply line using an active shunt circuit.

Using the active shunt circuit may comprise shunting a current flowing through the linear voltage regulator to ground.

In some embodiments, the load is a first load, and the method may further comprise supplying power to a second load through the supply line, wherein the first load and the second load may be disposed on top of a multi-layer interposer and the via passes through the multi-layer interposer.

Using the linear voltage regulator may comprise allowing a current to flow through the linear voltage regulator from a first terminal of the linear voltage regulator to a second terminal of the linear voltage regulator, the first terminal being characterized by an impedance less than that of the second terminal.

Allowing a current to flow through the linear voltage regulator may comprise allowing the current to flow from a source of a PMOS transistor to a drain of the PMOS transistor.

The foregoing summary is provided by way of illustration and is not intended to be limiting.

### BRIEF DESCRIPTION OF DRAWINGS

The accompanying drawings are not intended to be drawn to scale. In the drawings, each identical or nearly identical component that is illustrated in various figures is represented by a like numeral. For purposes of clarity, not every component may be labeled in every drawing.
FIG. 1 is a schematic diagram illustrating an SoC including a multi-layer interposer, in accordance with some embodiments of the present disclosure.
FIG. 2 is a circuit diagram of a portion of the SoC of FIG. 1 with a capacitor positioned between a supply line and a ground line, in accordance with some embodiments of the present disclosure.
FIG. 3 is a plot illustrating how the impedance of the supply line of FIG. 2 may vary as a function of the frequency, in accordance with some embodiments of the present disclosure.
FIG. 4 is a circuit diagram of a portion of the SoC of FIG. 1 with no capacitors positioned between the supply line and the ground line, in accordance with some embodiments of the present disclosure.
FIG. 5 is a block diagram illustrating an example of a circuit that may be included in the SoC of FIG. 1, in accordance with some embodiments of the present disclosure.
FIG. 6 is a circuit diagram illustrating a possible implementation of the circuit of FIG. 5, in accordance with some embodiments of the present disclosure.
FIG. 7 is a plot comparing the noise of the SoCs of FIG. 1 with and without the circuit of FIG. 5, in accordance with some embodiments of the present disclosure.

### DETAILED DESCRIPTION

The inventors have recognized and appreciated that certain systems-on-chip (SoC) suffer from the fact that noise generated in one circuit of the SoC may inadvertently couple to another circuit of the SoC. The noise coupling may significantly impair the overall performance of the SoC. Consider, for example, an SoC having several sub-circuits including a noisy digital circuit and a noise-sensitive analog circuit sitting next to the digital circuit. The digital circuit may generate noise due to the presence of transistors switching from one state to another several times per second. This type of noise is often referred to as "switching noise." The noise may inadvertently couple to the analog circuit. Because the analog circuit is particularly sensitive to noise, its operations may be substantially impaired.

The inventors have appreciated that one factor contributing to the noise coupling described above is the fact that the lines suppling power to the SoC have large impedances. Due to their complexities, SoC often require several different supply voltage levels. For example, certain circuits of the SoC may require supply voltage levels less than 1.2V to prevent damage to small transistors; other circuits of the SOC may require levels greater than 4V to enhance linearity; yet other circuits may require voltage levels in other ranges. The requirement for multiple voltage levels calls for the use of multiple additional supply lines. Thus, an overcrowding of supply lines may occur. One way to route multiple supply lines in spite of the overcrowding is to reduce the size of at least some of the supply lines. Reducing the size of a supply line, however, increases its impedance, thus promoting noise coupling between electronic circuits.

Large capacitors may be connected to a supply lines to counteract the effect of the line's impedance. Use of these capacitors, however, is often undesirable as it may require significant portions of real estate that may otherwise be used for other useful circuits.

The inventors have developed a solution to this problem that does not require large capacitors. The systems developed by the inventors use a voltage regulator configured to prevent noise present in a supply line from reaching a circuit of the SoC and for preventing noise generated in the circuit from reaching the supply line. The inventors have appreciated that blocking noise in two directions-from a supply line to a load and from the load to the supply line-significantly improves the overall noise performance of the SoC. The voltage regulator may include a linear voltage regulator coupled between the supply line and the load and an active shunt circuit coupled to the linear voltage regulator and to the ground line. The linear regulator may be designed to prevent noise generated at the load from reaching the supply line. The shunt active circuit may provide a path to ground for discharging noise coupled from the supply line.

As used herein, the term "ground" may encompass a "circuit ground" (e.g., a terminal of constant potential reference against which other potentials are referred to) and/or a "physical ground" (e.g., a physical connection to the earth). Thus, ground lines of the types described herein may be lines connected to circuit grounds and/or to physical grounds.

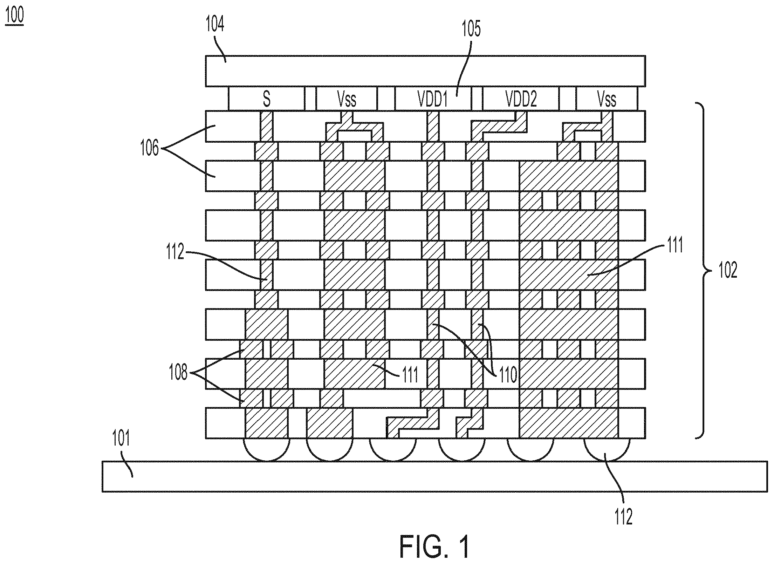

FIG. 1 is a schematic diagram illustrating an example of an SoC, in accordance with some embodiments. SoC 100 includes printed circuit board (PCB) 101, multi-layer interposer 102, and chip 104. Chip 104 can include a variety of electronic circuits, including for example microprocessors, memory units, input/output ports, RF and mixed-signal components, amplifiers, and/or other types of analog and/or digital systems.

Multi-layer interposer 102 facilitates power and signal delivery between chip 104 and PCB 101. As shown in FIG. 1, multi-layer interposer 102 includes multiple layers 106 and vias 108. Layers 106 may be stacked on one another and may be electrically connected to each other through the vias 108. Each layer 106 may include a conductive layer patterned to form arbitrary electrical interconnects. Vias 108 connect these electrical interconnects in the vertical direction. The ability to form arbitrary interconnects using layers 106 and vias 108 significantly enhances the design flexibility of chip 104 thus enabling a greater degree of electronic integration.

Given the presence of different types of electronic circuits in SoC 100, in some embodiments, it may be desirable to supply chip 104 with different voltage levels. Some digital circuits, for example, may require voltage levels less than 1.2V, while some analog circuits may require voltage levels greater than 4V. In some embodiments, the voltage levels may be generated outside the chip (e.g., on PCB 101) and may be delivered to chip 104 using interposer 102. In this way, additional chip real estate may be freed to accommodate more functionalities. Accordingly, multiple supply lines may be needed to route the different voltage levels to chip 104.

In the example of FIG. 1, supply lines 110 route respective supply voltage levels from PCB 101 to chip 104. Ground lines 111 connect the ground terminal of PCB 101 to the ground terminal of chip 104. Signal line 112 routes a certain signal between PCB 101 and chip 104. Multi-layer interposer 102 is in electrical communication with chip 104 by means of conductive pads 105, and with PCB 101 by means of contacts 112. The example of FIG. 1 depicts five pads 105, though any other suitable number of pads may be used. The pads labeled "VDD₁" and "VDD₂" serve as interfaces between supply lines 110 and chip 104. VDD1 indicates one voltage level and VDD2 indicates another voltage level. The pads labeled "VSS" serve as interfaces between ground lines 111 and chip 104. The pad labeled "S" serves as interface between signal line 112 and chip 104. Contacts 112 connect the supply, ground and signal lines to PCB 101. Contacts 112 may be implemented with copper pillars, ball grid arrays, solder balls, or any other suitable type of electric connection.

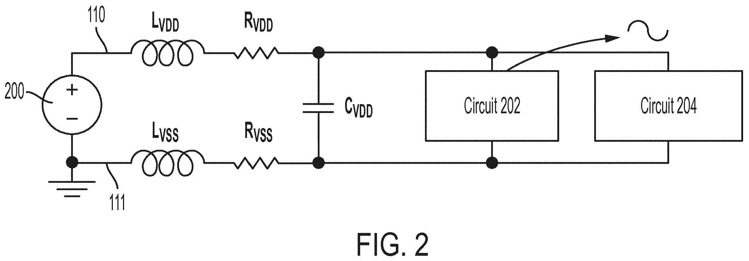

As discussed above, multiple supply lines may be used in some embodiments to provide various supply voltage levels to chip 104. For example, ten separate supply lines may be routed through interposer 102 to a chip operating with ten different voltage levels. At the same time, ground lines may be shared among multiple systems, even if these systems operate at different voltage levels. This results in possibly less ground lines than supply lines, and greater flexibility in the way the ground lines are routed relative to the supply lines. In the example of FIG. 1, multiple vias 108 are used in parallel between adjacent layers 106 to support ground line 111. By contrast, only one via supports supply line 110 between adjacent layers 106 (though not all embodiments are limited in this respect). More generally, the limited flexibility with which supply lines 110 can be routed throughout interposer 102 can result in the supply lines having access to fewer vias than ground lines 111. This, in turn, can result in the supply lines having higher impedances relative to the ground lines. The higher impedance can promote noise coupling between circuits of chip 104, as shown schematically in FIG. 2

FIG. 2 is a block diagram illustrating a portion of SoC 100, according to some embodiments. In this example, voltage source 200 (on PCB 101) is coupled to circuits 202 and 204 (on chip 104) through a supply line 110 and a ground line 111 (on interposer 102). Owing to the fact that supply line 110 is supported by fewer vias than ground line 111, the impedance of supply line 110 may be larger than that of ground line 111. For example, the inductance of the supply line (L_{VDD}) may be greater than the inductance of the ground line (L_{VSS}) and/or the resistance of the supply line (R_{VDD}) may be greater than the resistance of the ground line (R_{VSS}). The relatively large impedance of the supply line may promote noise coupling between circuits 202 and 204. Noise coupling between circuits is undesirable because it may impair their performance. Noise coupling between circuits may be serious in such circumstances in which one circuit is particularly noisy and another circuit is particularly sensitive to noise. Some digital circuits can be particularly noisy due to their switching nature. When a gate is switched, in fact, noise results in the form of unpredictable voltage fluctuation. Examples of circuits that are particularly sensitive to noise include analog circuits, whose linearity can be negatively affected by the presence of noise. Other examples of circuits that are particularly sensitive to noise include sensors, whose sensitivity to the quantity to be measured can be negatively affected by the presence of noise.

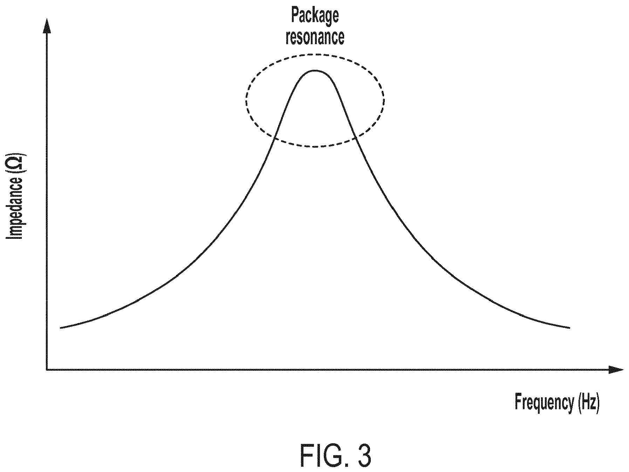

In some circumstances, noise coupling between circuits may give rise to unwanted harmonic oscillations. This is due to the existence of more than one pole in the frequency response of the supply line (e.g., one pole is caused by the line's intrinsic inductance and another pole is caused by the line's intrinsic capacitance). Multiple poles, in fact, can give rise to resonant frequency responses, as shown in FIG. 3. The frequency of the resonance depends on the geometry of the package, the number of vias supporting a line, the length of the line, etc. A frequency response of the type shown in FIG. 3 enhances noise coupling at and near the resonance, thus producing unwanted harmonic oscillations. Unfortunately, the resonant frequency of the line is difficult to measure. Thus, the resonant frequency is generally not known a priori and as result is difficult to filter out.

In some cases, large capacitors (e.g., with capacitances greater than 100pF, InF, or 10 nF) may be employed to reduce the impedance of a supply line, thereby reducing the ability of noise to couple through the line. Referring back to FIG. 2, a large capacitor C_{VDD} is connected to supply line 110 and ground line 111. The inventors have recognized, however, that use of large capacitors as shown in FIG. 2 may be undesirable in some circumstances. For example, such capacitors may occupy significant portions of the SoC that mat otherwise be used for other useful circuits. Hence, they tend to increase the overall cost of an SoC.

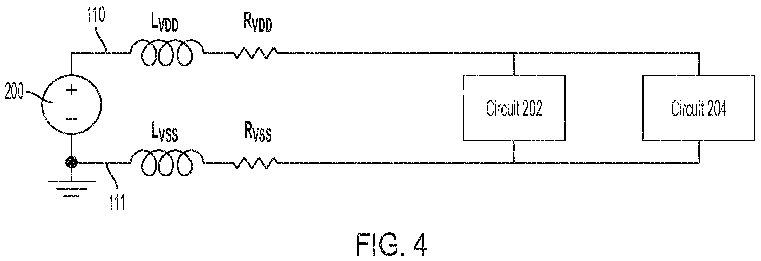

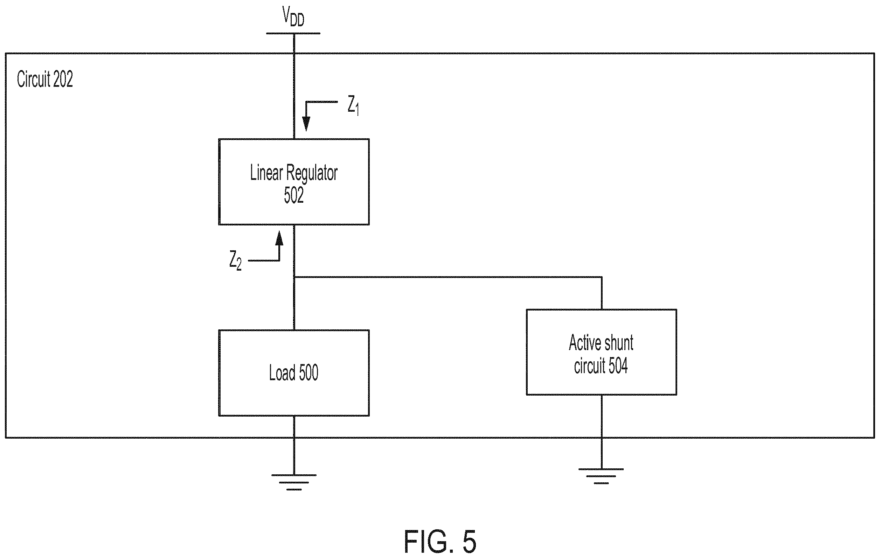

In some embodiments, noise coupling between circuits of an SoC may be reduced without having to resort to large capacitors as shown in FIG. 4. Some embodiments relate to voltage regulators configured to 1) prevent (or at least limit) noise present on a supply line from coupling to a circuit and 2) to prevent (or at least limit) noise generated at the circuit from coupling to the supply line. An example of such a voltage regulator is illustrated in FIG. 5, in accordance with some embodiments. FIG. 5 is a block diagram of a circuit 202 that may be used in connection with the SoC of FIG. 4 to limit noise coupling to circuit 204.

In the example of FIG. 5, circuit 202 includes load 500, linear regulator 502 and active shunt circuit 504. Load 500 may include any type of electronic circuit, including analog, digital, mixed-signal, and/or RF circuits, among others. Linear regulator 502 and active shunt circuit 504 may collectively be configured to prevent (or at least limit) noise present on supply line 110 from coupling to load 500, and to prevent (or at least limit) noise generated at load 500 from coupling to supply line 110. Linear regulator 502 may be implemented with any of numerous designs, including but not limited to low-drop out (LDO) regulators.

In some embodiments, preventing or limiting supply noise from coupling to load 500 may involve providing an alternative path to ground (other than the load) through which noise can be discharged. Accordingly, active shunt circuit 504 may include circuitry for actively pulling a portion of the current flowing through linear regulator 502 to ground. Active shunt circuit 504 may be implemented using any suitable active circuit (e.g., with at least one transistor and/or diode), as example of which is described further below. Other implementations of active shunt circuit 504 involve the use of Zener diodes. In some embodiments, active shunt circuit 504 may be arranged in parallel to load 500.

In some embodiments, preventing or limiting noise generated at load 500 (e.g., switching noise) from coupling to supply line 110 may involve providing a high impedance at the terminal of linear regulator 502 seen by load 500. In FIG. 5, Z₂ represents the impedance of linear regulator 502 seen by load 500. In some embodiments, impedance Z₂ may be greater than 100Ω, greater than 1KΩ, greater than 10KΩ, greater than 100kΩ or greater than 1MΩ. Such a large impedance may provide a barrier preventing noise generated at load 500 from reaching supply line 110. Z₁, the impedance of linear regulator 502 seen by supply line 110 may be less than Z₂. For example, impedance Z₁ may be less than 10KΩ, less than 5KΩ, less than 1KΩ, less than 100Ω or less than 10Ω. In some circumstances, such a low impedance may promote coupling of supply noise to circuit 202. Nonetheless, the coupled noise may be discharged to ground via active shunt circuit 504, as discussed above.

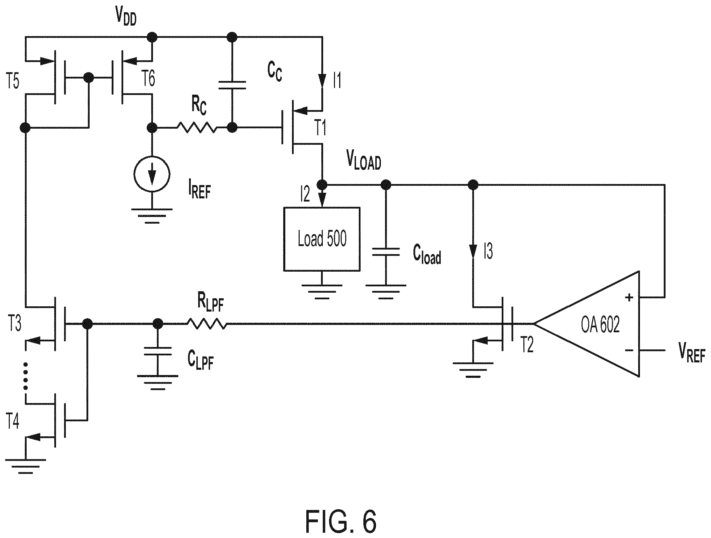

An example of an implementation of circuit 202 is illustrated in FIG. 6, in accordance with some embodiments. In this example, linear regulator 502 comprises PMOS transistor T1, and active shunt circuit 504 comprises operational amplifier (OA) 602 and transistor T2. A capacitor C_{load} is used to suppress high-frequency noise from load (500) and supply line (110) particularly at frequency beyond active shunt circuit's maximum operation speed. The circuit of FIG. 6 further includes a feedback circuit comprising a current mirror, a low-pass filter and a circuit for ensuring the stability of the system. In this example, resistors R_{LPF} and capacitors C_{LPF} serve as a low-pass filter, transistors T3, T4, T5 and T6 and current generator I_{REF} serve as a current mirror, and resistor Rc and capacitors C_{C} are arranged to set the dominant pole of the system, thereby ensuring the overall stability of the system.

The current provided to the load (I2), the current flowing through transistor T1 (I1), and the current flowing through transistor T2 (I3) are related according to the following expression: I1=I2+I3.

OA 602 and transistor T2 collectively promote discharge of supply noise to ground while maintaining the voltage (V_{LOAD}) at the input node of load 500 substantially unchanged. In this example, OA 602 has an output terminal coupled to the gate of transistor T2. Transistor T2 is configured to pull current I3 to ground, thereby providing the supply noise with a path to ground. OA 602 is arranged to ensure that the current I3 does not significantly alter the voltage provided as input to load 500.

In the embodiment of FIG. 6, transistor T1 is a PMOS transistor. Of course, other types of transistors are also possible including PNP bipolar junction transistors. The PMOS transistor may be arranged with the source coupled (directly coupled or indirectly coupled) to the supply line and the drain coupled (directly coupled or indirectly coupled) to the input of load 500. Hence, the transistor's impedance seen by the supply line is the transistor's source impedance and the transistor's impedance seen by the load is the transistor's drain impedance. The drain impedance of transistor T1 may be sufficiently large (e.g., greater than 100Ω, 1KΩ, 10KΩ, 100KΩ or 1MΩ) to block noise generated at load 500 from reaching the supply line. At the same time, however, the low impedance seen by the supply line may provide an unwanted path for supply noise to pass through the transistor. Nonetheless, the majority (or at least a portion) of the supply noise passing through transistor T1 may be discharged to ground, rather than coupling to load 500, via transistor T2.

In some embodiments, the magnitude of the current I3 may be set, at least in part, by the size of transistor T2 relative to transistors T3and T4. In some embodiments, for example, the size of transistor T2 may be N/M times larger than the size of transistor T3 (e.g., transistor T2 has drain and source wells that are N/M times wider than those of transistor T3). M represents the number of devices disposed in series with transistors T3 and T4. In at least some of these embodiments, current I3 may be given by the following expression: I3=N I_{REF}.

In some embodiments, setting N to a value greater than 1 may further reduce the extent to which noise generated at load 500 couples to the supply line. In this way, in fact, the current flowing through transistors T3 and T5 is N times smaller than the current flowing through transistor T2, and the noise transferred from transistor T2 to transistor T3 is attenuated by a factor N. In some embodiments, N may be between 10 and 1000, between 10 and 500, between 10 and 100, between 50 and 1000, between 50 and 500, or between 50 and 100, among other possible ranges. Transfer of noise from transistor T2 to transistor T3 (and hence, to the supply line) may be further attenuated by the presence of resistor R_{LPF} and capacitor C_{LPF}. The resistor R_{LPF} and capacitor C_{LPF} may serve as a low pass filter, and may filter frequencies outside the bandpass of the filter, including in some embodiments the resonant frequency of the system (see FIG. 3).

Resistor R_{C} and capacitor C_{C} may be selected to set the primary pole of the system. In some embodiment, the primary pole may be set sufficiently far from the other poles of the system such that, at the frequencies around the systems' resonant frequency, the circuit behaves as a single pole circuit. In this way, the circuit may be exhibit a sufficiently large phase margin to reduce the possibility that the supply noise be amplified through a positive feedback loop. Resistor R_{C} and capacitor C_{C} may alternatively or additionally be selected to limit the source-gate voltage of transistor T1, thus further reducing the extent to which supply noise couples to load 500 at high frequencies. In this case, in fact, capacitor C_{c} may effectively become a short-circuit coupling transistor T1's source to its gate (such that Vgs = 0). Having Vgs = 0, supply noise is not amplified.

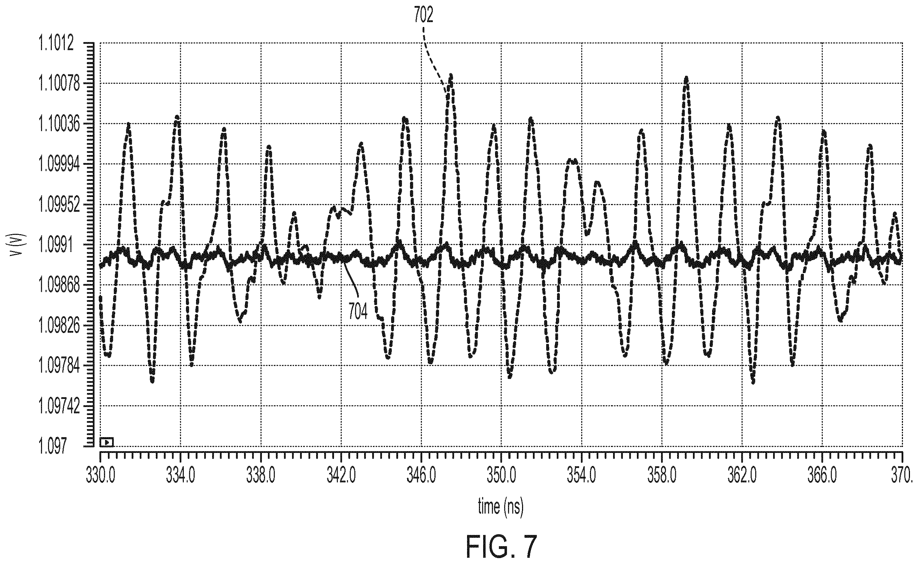

FIG. 7 is a plot illustrating how the system of FIG. 6 rejects noise, according to one example. The curve labeled 702 represents the noise that would appear at load 500 absent linear regulator 502 and active shunt circuit 504. As shown, the noise exhibits an oscillatory behavior with a frequency set by the resonant frequency of the system (e.g., the resonant frequency of FIG. 3). The curve labeled 704 represents the noise present at load 500 when linear regulator 502 and active shunt circuit 504 are employed as shown in FIG. 5. In this case, the oscillations are substantially attenuated, and the overall noise coupled to the load is significantly reduced.

Use of ordinal terms such as "first", "second", "third", etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

Also, the phraseology and terminology used herein is for the purpose of description and should not be regarded as limiting. The use of "including", "comprising", "having", "containing" or "involving" and variations thereof herein, is meant to encompass the items listed thereafter and equivalents thereof as well as additional items.

The use of "coupled" or "connected" is meant to refer to circuit elements, or signals, that are either directly linked to one another or through intermediate components.

The terms "approximately", "substantially," and "about" may be used to mean within ±20% of a target value in some embodiments, within ±10% of a target value in some embodiments, within ±5% of a target value in some embodiments, and within ±2% of a target value in some embodiments. The terms "approximately" and "about" may include the target value.

## Claims

1. A system-on-chip (SoC) comprising:
a chip comprising a first electronic circuit and a second electronic circuit; and
a multi-layer interposer comprising:
a ground line including at least one via and connecting the first and second electronic circuits to a ground terminal; and
a supply line including at least one via and connecting the first and second electronic circuits to a power supply;
the first electronic circuit comprising:
a load;
a linear voltage regulator coupled between the supply line and the load; and
an active shunt circuit coupled to the linear voltage regulator and to the ground line.

2. The SoC of claim 1, wherein the linear voltage regulator has a first impedance and a second impedance, the first impedance representing an impedance of the linear voltage regulator seen by the supply line and the second impedance representing an impedance of the linear voltage regulator seen by the load, the first impedance being lower than the second impedance.

3. The SoC of claim 2, wherein the first impedance represents a source impedance or an emitter impedance, and the second impedance represents a drain impedance or a collector impedance.

4. The SoC of any preceding claim, wherein the linear voltage regulator comprises a low-drop out (LDO) regulator.

5. The SoC of any preceding claim, wherein the first electronic circuit is a digital circuit and the second electronic circuit is an analog circuit.

6. The SoC of any preceding claim, wherein the active shunt circuit comprises an operational amplifier and a transistor, the operational amplifier having an output coupled to a gate or a base of the transistor.

7. The SoC of any preceding claim, wherein the SoC lacks capacitors coupled between the supply line and the source line and having capacitances greater than InF.

8. The SoC of any preceding claim, wherein the load is a digital circuit.

9. The SoC of any preceding claim, wherein the first electronic circuit further comprises a feedback circuit coupling the active shunt circuit to the linear voltage regulator, the feedback circuit comprising a current mirror.

10. The SoC of any preceding claim, wherein the linear voltage regulator comprises a PMOS transistor coupled between the load and the supply line.

11. A method for supplying power to a load, the method comprising:
providing a supply voltage to a linear voltage regulator through a supply line comprising at least one via, the linear voltage regulator being coupled to the load;
reducing coupling of noise present at the supply line to the load using the linear voltage regulator; and
reducing coupling of noise generated at the load to the supply line using an active shunt circuit.

12. The method of claim 11, wherein using the active shunt circuit comprises shunting a current flowing through the linear voltage regulator to ground.

13. The method of any one of claims 11 and 12, wherein the load is a first load, and wherein the method further comprises supplying power to a second load through the supply line, wherein the first load and the second load are disposed on top of a multi-layer interposer and the via passes through the multi-layer interposer.

14. The method of any one of claims 11, 12 and 13, wherein using the linear voltage regulator comprises allowing a current to flow through the linear voltage regulator from a first terminal of the linear voltage regulator to a second terminal of the linear voltage regulator, the first terminal being **characterized by** an impedance less than that of the second terminal.

15. The method of claim 14, wherein allowing a current to flow through the linear voltage regulator comprises allowing the current to flow from a source of a PMOS transistor to a drain of the PMOS transistor.
